# EUROPÄISCHE PATENTSCHRIFT

(11) **EP 0 915 570 B1**
(45) Veröffentlichungstag und Bekanntmachung des Hinweises auf die Patenterteilung: **31.03.2004**
(21) Anmeldenummer: 98120731.9
(22) Anmeldetag: 31.10.1998
(51) Int. Cl.: H03L 7/20, H03L 7/091

(54) **Sampling-PLL für hochauflösende Radarsysteme**
Sampling PLL for high resolution radar systems
Boucle à verrouillage de phase à échantillonnage pour système radar à haute résolution

(30) Priorität: 04.11.1997 DE 19748608
(43) Veröffentlichungstag der Anmeldung: 12.05.1999
(73) Patentinhaber: EADS Deutschland GmbH, 81663 München (DE)
(72) Erfinder: Häberle, Babette, 89134 Blaustein (DE); Ludwig, Walter, 89278 Nersingen (DE); Schuster, Harald, 89231 Neu-Ulm (DE)
(74) Vertreter: Meel, Thomas

(56) Entgegenhaltungen:
- US-A- 4 682 122
- US-A- 5 184 093
- ZVI GALANI ET AL: "AN OVERVIEW OF FREQUENCY SYNTHESIZERS FOR RADARS" IEEE TRANSACTIONS ON MICROWAVE THEORY AND TECHNIQUES, IEEE INC. NEW YORK, US, Bd. 39, Nr. 5, 1. Mai 1991 (1991-05-01), Seiten 782-790, XP000201473 ISSN: 0018-9480
- PAUL H. YOUNG: "Electronic Communication Techniques" , MERRIL PUBLISHING COMPANY XP002208921 * Seite 444 - Seite 451; Abbildungen 10-37 *

## Beschreibung

Die Erfindung betrifft eine eine Sampling-PLL für hochauflösende Radarsysteme gemäß dem Oberbegriff des Patentanspruchs 1.

Aus US 5,184,093 sind PLLs mit einem Frequenzteiler im Rückkopplungszweig bekannt. Für die Verwendung in hochauflösenden Radarsystemen sind derartige PLLs allerdings nicht geeignet, da das in den PLLs auftretende Teilerrauschen die Frequenzstabilität des Ausgangssignals zu stark beeinträchtigt.

Eine Verbesserung bezüglich des Phasenrauschens am PLL-Ausgang wird z.B. in IEEE Transaction On Microwave Theory And Techniques, IEEE Inc New York, US(01-05-1991), 39(5), 782-790 beschrieben. Es ist als Ausführungsvariante eine PLL angegeben, bei welcher der Phasenvergleich auf einer definierten Harmonischen des Referenzsignals erfolgt. Der höhere technische Aufwand dieser Variante ermöglicht auch für die Frequenzvervielfachungen die Übertragung der realisierbaren Quarzoszillatorstabilitäten auf das Ausgangssignal der PLL. In dieser Variante erfolgt die Selektion einer bestimmten Oberwelle insbesondere bei großen Vielfachen der Referenzfrequenz indirekt durch die PLL. Diese kann als ein Bandpaß mit einer Bandbreite, die der Regelschleifenbandbreite entspricht, betrachtet werden. Die Auswahl einer bestimmten Frequenz erfolgt mit einem Pretuningprozeß, der z.B. mittels einer eingangs beschriebenen, konventionellen digitalen Regelschleife mit Frequenzteiler ausgeführt wird. Bei Verwendung eines YIG-Oszillators mit digitalem Treiber kann über den Treiber die Vorauswahl geschehen. Die eigentliche Regelung der PLL erfolgt über die Feinverstimmung des YIG-Oszillators.

Die Referenzfrequenz einer derartigen Sampling-PLL ist durch die geforderte Schrittweite festgelegt. Für die Erzeugung hoher Ausgangsfrequenzen sind deshalb sehr große Vervielfachungsfaktoren am Referenzoszillator erforderlich. Neben dem Problem der Erzielung einer genügend hohen Leistungsausbeute auf hohen Vielfachen der Referenzfrequenz, die zur Wahrung eines ausreichenden Abstandes zum thermischen Rauschen erforderlich ist, hebt jede Verdopplung der Referenzfrequenz das Phasenrauschen um 6dB an. Deshalb ist auch mit diesem Konzept die Frequenzstabilität beeinträchtigt, wenn in hochauflösenden Radarsystemen hohe Ausgangsfrequenzen bei kleiner Schrittweite gefordert sind.

Der Erfindung liegt die Aufgabe zugrunde, eine rauscharme Sampling-PLL für hochauflösende Radarsysteme zu schaffen.

Diese Aufgabe wird erfindungsgemäß durch die Merkmale des Patentanspruchs 1 gelöst. Weiterbildungen der Erfindung sind in den Unteransprüchen angegeben.

Die Erfindung verwendet vorteilhaft eine Eigenschaft von Quarzoszillatoren, die darin besteht, daß sich in einem Frequenzbereich von 5 MHz bis100 MHz Quarzoszillatoren mit etwa gleicher Phasennoiseperformance realisieren lassen. Aufbauend auf dieser Eigenschaft wird das Referenzsignal für die Sampling-PLL erfindungsgemäß als ein Linienspektrum mittels Frequenzmischung generiert. Damit können hohe Ausgangsfrequenzen mit kleineren Vervielfachungsfaktoren erzeugt werden. Wegen der gegebenen quadratischen Abhängigkeit des Phasenrauschens von den Vervielfachungsfaktoren tritt bei Verwendung der erfindungsgemäßen Lösung eine deutliche Stabilitätsverbesserung des Ausgangssignales ein.

Anhand der Zeichnung werden Ausführungsbeispiele der Erfindung näher erläutert.
- Fig.1: zeigt eine Sampling-PLL mit einer Referenzerzeugung gemäß dem Stand der Technik,
- Fig.2: zeigt eine Referenz, die durch Vervielfachung eines Linientripletts erzeugt ist und
- Fig.3: zeigt eine Referenz, die durch Mischung eines Kammspektrums mit einer höheren Einzelfrequenz ensteht.

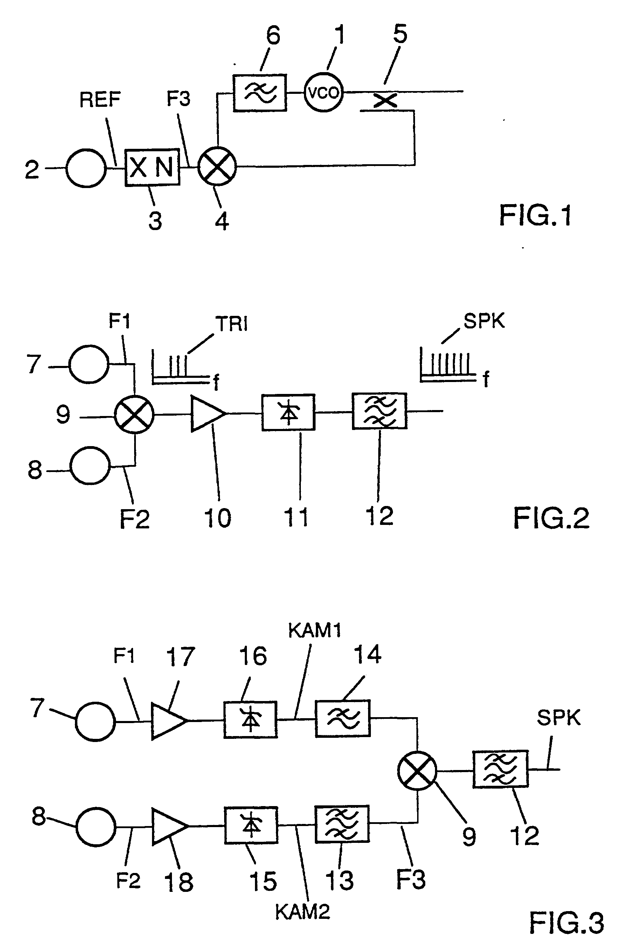

Die in Fig.1 gezeigte Sampling-PLL besteht aus einem steuerbaren Oszillator 1, Quarzoszillator 2, Vervielfacher 3, Mischer 4, Auskoppler 5 und einem Tiefpaß-Filter 6.

In dieser Sampling-PLL findet der Phasenvergleich in bekannter Weise auf einer vorgebbaren Oberwelle F3 des Referenzsignales REF statt. Dazu durchläuft das Referenzsignal REF den Vervielfacher 3 bevor es auf den Mischer 4 zum Phasenvergleich mit einem ausgekoppelten Teil des Ausgangssignal der PLL gegeben ist. Das Ausgangssignal des Mischers 3 dient nach einer Filterung in dem Tiefpaß-Filter 6 als Stellsignal für den steuerbaren Oszillator 1. Dieser Oszillator 1 ist ein spannungsgesteuerter Oszillator VCO. Es könnte z.B. auch ein YIG-Oszillator Verwendung finden.

Zur Verbesserung des Phasenrauschens am Ausgang einer derartig ausgebildeten Sampling-PLL wird erfindungsgemäß die Referenzerzeugung so verändert, daß dabei große Vervielfachungsfaktoren vermieden werden. Es werden zwei Varianten zur Lösung der zugrundeliegenden Aufgabe vorgeschlagen. In beiden Lösungen werden die Referenzfrequenzen einem Linienspektrum entnommen, das aus der Mischung zweier Quarzoszillatorfrequenzen ensteht. Die Lösung gemäß Fig.2 erfordert einen geringen Hardwareaufwand bei gegebenenfalls möglichen Einschränkungen bezüglich der Vollständigkeit und Gleichmäßigkeit des erzeugten Linienspektrums. Die Lösung gemäß Fig.3 ist ein aufwendigeres Verfahren und liefert ein vollständiges und gleichmäßiges Linienspektrum.

Die in Fig.2 gezeigte Referenzerzeugung ersetzt die Referenzerzeugung der in Fig.1 gezeigten Sampling-PLL. Die erfindungsgemäße Referenzerzeugung besteht aus einem Quarzoszillator 7, Quarzoszillator 8, Mischer 9, Verstärker 10, Step-Recovery-Dioden-Vervielfacher 11 und einem Bandpaß-Filter 12.

Der Quarzoszillator 7 erzeugt eine niedrige Quarzoszillatorfrequenz F1 im Wert von 5MHz und der Quarzoszillator 8 eine hohe Oszillatorfrequenz F2 im Wert von 100 MHz. Es können auch Frequenzen F1 und F2 mit davon abweichenden Werten verwendet werden, wenn dafür eine ausreichende Kurzzeitstabilität (Phasennoiseperformance) realisierbar ist. Die Frequenzen sind auf den Mischer 9 gegeben, der daraus in bekannter Weise ein Linientriplett TRI erzeugt. Zur Wahrung der Kohärenz zwischen den Einzellinien müssen die beiden Quarzoszillatoren 7 und 8 synchronisiert sein. Mittel zum Synchronisieren der beiden Frequenzen sind dem Fachmann bekannt und in Fig.2 aus Gründen einer klaren Darstellung der erfindungsgemäßen Lösung nicht aufgezeigt; z.B. können beide Quarzoszillatoren in eine separate PLL eingebunden sein. Dabei ist eine möglichst kleine Loopbandbreite anzustreben, damit auch bei kleinen Offsetfrequenzen unkorrelierte Seitenbänder vorliegen. Andernfalls kann es auf dem Mischer 9 zu Spannungsadditionen anstelle von Leistungsadditionen kommen, was wiederum eine Einbuße von max 3dB am Phasenrauschen bedeuten kann.

Das Linientriplett TRI wird in dem Verstärker 10 ausreichend verstärkt und auf den Step-Recovery-Dioden-Vervielfacher 11 gegeben, der daraus ein Linienspektrum SPK erzeugt. Eventuell muß das Linienspektrum an den Rändern durch ein nachgeschaltetes Bandpaß-Filter 12 begrenzt werden. Die weitgehend kontinuierliche Verteilung des so erzeugten Linienspektrums SPK kann man sich durch das Enstehen von Intermodulationsprodukten höherer Ordnung erklären. Dies kann durch eine Art "FM-Markierung" einer Quelle nachgewiesen werden. Daraus wiederum resultieren die effektiven Vervielfachungsgrade, die ihrerseits die Phasenrauscheigenschaften bestimmen.

Das obere und das untere Seitenband des so erzeugten Linientripletts TRI haben eine unterschiedliche Phasenlage. Dies kann bei einigen Kombinationen der Quarzoszillatorfrequenzen F1 und F2 dazu führen, daß einzelne Linien im Spektrum nahezu ausgelöscht werden, wodurch die Vollständigkeit und Gleichmäßigkeit des Linienspektrums SPK beeinträchtigt sein kann.

Die Referenzerzeugung gemäß Fig.3 besteht wiederum aus den beiden Quarzoszillatoren 7 und 8, dem Mischer 9 und dem ausgangsseitigen Bandpaß-Filter 12. Abweichend zu der vorangehend beschriebenen Lösung gemäß Fig.2 sind die synchronisierten Quarzoszillatorfrequenzen F1 und F2 nicht direkt auf den Mischer 9 zur Erzeugung eines Linientripletts TRI gegeben.

In dieser Lösung wird aus der niedrigen Quarzoszillatorfrequenz F1 ein Kammspektrum KAM1 erzeugt, das mit einer Oberwelle F3 der hohen Quarzoszillatorfrequenz F2 auf den Mischer 9 zur Erzeugung des Linienspektrums SPK gegeben ist. Das Kammspektrum KAM1 wird nach einer Verstärkung der niedrigen Quarzoszillatorfrequenz F1 aus dieser mit einem Step-Recovery-Dioden-Vervielfacher 16 und einem nachgeschalteten Tiefpaß-Filter 14 erzeugt. Die obere Grenze des Kammspektrums KAM1 soll mindestens bis F2/2 reichen. Die Oberwelle F3 wird mittels eines Bandpaß-Filters 13 aus einem Kammspektrum KAM2 herausgefiltert, das mit einem Step-Recovery-Dioden-Vervielfacher 15 aus der mit dem Verstärker 18 verstärkten hohen Quarzoszillatorfrequenz F2 erzeugt ist.

Mit einer niedrigen Quarzoszillatorfrequenz F1 von 5 MHz, einer hohen Quarzoszillatorfrequenz F2 von 100 MHz, einer Obergrenze des Kammspektrums KAM1 bei 50 MHz und einer Vervielfachung der hohen Quarzoszillatorfrequenz F2 um den Faktor 10 läßt sich mit der Lösung gemäß Fig.3 ein Linienspektrum von 950 MHz bis 1050 MHz mit einer Schrittweite von 5MHz erzeugen. Das Phasenrauschen würde bei der effektiven Vervielfachung von 10 um maximal 20 dB angehoben werden. Sollte mit dem Stand der Technik gemäß Fig.1 ein Linienspektrum mit einer Schrittweite von 5 MHz bei 1GHz erzeugt werden, so würde die 5 MHz-Referenz um den Faktor 200 vervielfacht werden müssen und damit das Phasenrauschen um 46 dB angehoben werden. Die erfindungsgemäße Lösung gemäß Fig.3 verbessert bei den voranstehend gewählten Randbedingungen die Phasenrauschperformance somit um mindestens 20 dB.

Wird ein Linienspektrum benötigt, das breiter als F2 ist, so muß das Bandpaß-Filter 13 umschaltbar sein, so daß benachbarte Oberwellen F3 dem Mischer 9 zugeführt werden können.

Auf die Selektion einzelner Frequenzlinien aus dem Linienspektrum SPK zur Durchführung des Phasenvergleichs auf dem Mischer 4 der Sampling PLL ist in der Beschreibung und Zeichnung nicht eingegangen, da dem Fachmann dafür beliebige Mittel zur Verfügung stehen.

## Patentansprüche

1. Sampling-PLL für hochauflösende Radarsysteme mit einem steuerbaren Frequenzoszillator (1) dessen Ausgangssignal teilweise in einen Rückkopplungszweig ausgekoppelt und in einem Phasenvergleicher (4) mit einem Referenzsignal (REF) verglichen ist, wobei das Referenzsignal (REF) ein Linienspektrum (SPK) ist, zu dessen Generierung mindestens ein Quarzoszillator (7, 8) und Mittel (9, 11) zur Erzeugung von Linienspektren vorgesehen sind, **dadurch gekennzeichnet, dass** zur Erzeugung des Referenzsignals (REF) ein erster Quarzoszillator (7) mit einer niedrigen Oszillatorfrequenz (F1) und ein zweiter Quarzoszillator (8) mit einer hohen Oszillatorfrequenz (F2) vorhanden sind, wobei die Oszillatorfrequenzen (F1, F2) synchronisiert sind und einem Mischer (9) zugeführt sind.

2. Sampling-PLL nach Anspruch 1, **dadurch gekennzeichnet, daß** bei der Mischung der beiden Quarzoszillatorfrequenzen (F1,F2) ein Linientriplett (TRI) erzeugt wird, das verstärkt und anschließend auf einen Step-Recovery-Dioden-Vervielfacher (11) gegeben wird, an dessen Ausgang das Linienspektrum (SPK) ensteht.

3. Sampling-PLL nach Anspruch 2, **dadurch gekennzeichnet, daß** das Linienspektrum (SPK) ein Bandpaß-Filter (12) durchläuft, bevor die Referenzfrequenzen entnommen werden.

4. Sampling-PLL nach Anspruch 1, **dadurch gekennzeichnet, daß** die niedrige Quarzoszillatorfrequenz (F1) in ein Kammspektrum (KAM1) vervielfacht wird und zur Erzeugung des Linienspektrums (SPK) mit mindestens einer Oberwelle (F3) der hohen Quarzoszillatorfrequenz (F2) gemischt ist.

5. Sampling-PLL nach Anspruch 4, **dadurch gekennzeichnet, daß** das Kammspektrum(KAM1) mit seiner oberen Frequenz mindestens bis zur halben hohen Quarzoszillator-frequenz (F2) reicht.

6. Sampling-PLL nach einen der Ansprüche 4 oder 5, **dadurch gekennzeichnet, daß** das Kammspektrum (KAM1) aus der niedrigen Quarzoszillatorfrequenz (F1) mit einem Step-Recovery-Dioden-Vervielfacher (16) und einem nachgeschalteten Tiefpaß-Filter (14) erzeugt ist und daß die Oberwellen (F3) mit einem Bandpaß-Filter (13) aus einem Kammspektrum (KAM2) herausgefiltert sind, das aus der hohen Quarzoszillatorfrequenz (F2) mit einem Step-Recovery-Dioden-Vervielfacher (15) erzeugt ist.

7. Sampling-PLL nach Anspruch 4 oder 5, **dadurch gekennzeichnet, daß** zur Verbreiterung des Linienspektrums (SPK) das Kammspektrum (KAM1) nacheinander mit mehreren, benachbarten Oberwellen (F3) gemischt ist.

8. Sampling-PLL nach Anspruch 7, **dadurch gekennzeichnet, daß** das Kammspektrum (KAM1) aus der niedrigen Quarzoszillatorfrequenz (F1) mit einem Step-Recovery-Dioden-Vervielfacher (16) und einem nachgeschalteten Tiefpaß-Filter (14) erzeugt ist und daß die Oberwellen mit einem schaltbaren Bandpaßfilter- Filter (13) aus einem Kammspektrum (KAM2) herausgefiltert sind, das aus der hohen Quarzoszillatorfrequenz (F2) mit einem Step-Recovery-Dioden-Vervielfacher (15) erzeugt ist.

9. Sampling-PLL nach einem der Ansprüche 1 bis 8, **dadurch gekennzeichnet, daß** die niedrige Quarzoszillatorfrequenz (F1) 5 MHz und die hohe Quarzoszillatorfrequenz ( F2) 100 MHz beträgt.

## Claims

1. Sampling PLL for high-resolution radar systems having a controllable frequency oscillator (1) whose output signal is partially output into a feedback branch and is compared in a phase comparator (4) with a reference signal (REF), with the reference signal (REF) being a line spectrum (SPK) for whose generation at least one crystal oscillator (7, 8) and means (9, 11) for production of line spectra are provided, **characterized in that** a first crystal oscillator (7) with a low oscillator frequency (F1), and a second crystal oscillator (8) with a high oscillator frequency (F2), are provided in order to produce the reference signal (REF), with the oscillator frequencies (F1, F2) being synchronized and being supplied to a mixer (9).

2. Sampling PLL according to Claim 1, **characterized in that**, during the mixing of the two crystal oscillator frequencies (F1, F2), a line triplet (TRI) is produced, which is amplified and is then passed to a step recovery diode multiplier (11), at whose output the line spectrum (SPK) is produced.

3. Sampling PLL according to Claim 2, **characterized in that** the line spectrum (SPK) passes through a bandpass filter (12) before the reference frequencies are extracted.

4. Sampling PLL according to Claim 1, **characterized in that** the low crystal oscillator frequency (F1) is multiplied into a comb spectrum (KAM1) and is mixed with at least one harmonic (F3) of the high crystal oscillator frequency (F2) in order to produce the line spectrum (SPK).

5. Sampling PLL according to Claim 4, **characterized in that** the upper frequency of the comb spectrum (KAM1) extends at least up to half the high crystal oscillator frequency (F2).

6. Sampling PLL according to one of Claims 4 or 5, **characterized in that** the comb spectrum (KAM1) is produced from the low crystal oscillator frequency (F1) by means of a step recovery diode multiplier (16) and a downstream low-pass filter (14), and **in that** the harmonics (F3) are filtered out of a comb spectrum (KAM2) by means of a bandpass filter (13), with this comb spectrum (KAM2) being produced from the high crystal oscillator frequency (F2) by means of a step recovery diode multiplier (15).

7. Sampling PLL according to Claim 4 or 5, **characterized in that**, in order to broaden the line spectrum (SPK), the comb spectrum (KAM1) is mixed successively with two or more adjacent harmonics (F3).

8. Sampling PLL according to Claim 7, **characterized in that** the comb spectrum (KAM1) is produced from the low crystal oscillator frequency (F1) by means of a step recovery diode multiplier (16) and a downstream low-pass filter (14), and **in that** the harmonics are filtered out of a comb spectrum (KAM2) by means of a switchable bandpass filter (13), which comb spectrum (KAM2) is produced from the high crystal oscillator frequency (F2) by means of a step recovery diode multiplier (15).

9. Sampling PLL according to one of Claims 1 to 8, **characterized in that** the low crystal oscillator frequency (F1) is 5 MHz, and the high crystal oscillator frequency (F2) is 100 MHz.

## Revendications

1. Boucle à verrouillage de phase à échantillonnage pour systèmes radar à haute résolution avec un oscillateur à fréquence réglable (1) dont le signal de sortie est découplé en partie dans une branche de rétroaction et est comparé à un signal de référence (REF) dans un comparateur de phases (4), dans laquelle le signal de référence (REF) est un spectre de lignes (SPK), pour la production duquel il est prévu au moins un oscillateur à quartz (7, 8) et des moyens (9, 11) pour produire des spectres de lignes, **caractérisée en ce qu'**il est prévu pour la production du signal de référence (REF) un premier oscillateur à quartz (7) avec une basse fréquence d'oscillateur (F1) et un deuxième oscillateur à quartz (8) avec une haute fréquence d'oscillateur (F2), les fréquences d'oscillateur (F1, F2) étant synchronisées et étant envoyées à un mélangeur (9).

2. Boucle à verrouillage de phase à échantillonnage selon la revendication 1, **caractérisée en ce que**, lors du mélange des deux fréquences d'oscillateur (F1, F2), on produit un triplet de lignes (TRI) qui est amplifié et ensuite transmis à un multiplicateur à diode de commutation à mémoire électrostatique (11), à la sortie duquel le spectre de lignes (SPK) apparaît.

3. Boucle à verrouillage de phase à échantillonnage selon la revendication 2, **caractérisée en ce que** le spectre linéaire (SPK) traverse un filtre à bande passante (12), avant que les fréquences de référence soient prélevées.

4. Boucle à verrouillage de phase à échantillonnage selon la revendication 1, **caractérisée en ce que** la basse fréquence d'oscillateur à quartz (F1) est multipliée en un spectre à peigne (KAM1) et est mélangée avec au moins une harmonique (F3) de la haute fréquence d'oscillateur à quartz (F2) pour produire le spectre de lignes (SPK).

5. Boucle à verrouillage de phase à échantillonnage selon la revendication 4, **caractérisée en ce que** le spectre en peigne (KAM1) avec sa fréquence plus élevée atteint au moins la moitié de la haute fréquence d'oscillateur à quartz (F2).

6. Boucle à verrouillage de phase à échantillonnage selon l'une quelconque des revendications 4 ou 5, **caractérisée en ce que** le spectre à peigne (KAM1) est produit à partir de la basse fréquence d'oscillateur à quartz (F1) avec un multiplicateur à diode de commutation à mémoire électrostatique (16) et un filtre passe-bas qui suit (14) et **en ce que** les harmoniques (F3) sont filtrées avec un filtre passe-bande (13) hors d'un spectre en peigne (KAM2), qui est produit à partir de la haute fréquence d'oscillateur à quartz (F2) avec un multiplicateur à diode de commutation à mémoire électrostatique (15).

7. Boucle à verrouillage de phase à échantillonnage selon la revendication 4 ou 5, **caractérisée en ce que** le spectre en peigne (KAM1) est mélangé successivement avec plusieurs harmoniques voisines (F3) pour élargir le spectre de lignes (SPK).

8. Boucle à verrouillage de phase à échantillonnage selon la revendication 7, **caractérisée en ce que** le spectre en peigne (KAM1) est produit à partir de la basse fréquence d'oscillateur à quartz (F1) avec un multiplicateur à diode de commutation à mémoire électrostatique (16) et un filtre passe-bas qui suit (14) et **en ce que** les harmoniques sont filtrées avec un filtre passe-bande commutable (13) hors d'un spectre en peigne (KAM2), qui est produit à partir de la haute fréquence d'oscillateur à quartz (F2) avec un multiplicateur à diode de commutation à mémoire électrostatique (15).

9. Boucle à verrouillage de phase à échantillonnage selon l'une quelconque des revendications 1 à 8, **caractérisée en ce que** la basse fréquence d'oscillateur à quartz (F1) vaut 5 MHz et la haute fréquence d'oscillateur à quartz (F2) vaut 100 MHz.
